# EUROPEAN PATENT SPECIFICATION

(11) **EP 3 648 153 B1**
(45) Date of publication and mention of the grant of the patent: **04.01.2023**
(21) Application number: 17916094.0
(22) Date of filing: 30.06.2017
(51) Int. Cl.: H01L 31/0224, H01L 21/68

(54) **SUBSTRATE POSITIONING DEVICE AND SUBSTRATE POSITIONING METHOD**
SUBSTRATPOSITIONIERUNGSVORRICHTUNG UND SUBSTRATPOSITIONIERUNGSVERFAHREN
DISPOSITIF DE POSITIONNEMENT DE SUBSTRAT ET PROCÉDÉ DE POSITIONNEMENT DE SUBSTRAT

(43) Date of publication of application: 06.05.2020
(73) Proprietor: TOSHIBA MITSUBISHI-ELECTRIC INDUSTRIAL SYSTEMS CORPORATION, Chuo-ku Tokyo 104-0031 (JP)
(72) Inventor: YAMADA Yoshihito, Tokyo 104-0031 (JP)
(74) Representative: Winter, Brandl - Partnerschaft mbB
(86) International application number: PCT/JP2017/024071
(87) International publication number: WO 2019/003403

(56) References cited:
- WO-A1-2009/119772
- JP-A- H1 068 918
- JP-A- 2003 171 146
- JP-A- 2003 229 470
- JP-A- 2003 229 470
- JP-A- 2006 344 675
- JP-A- 2006 344 675
- JP-A- 2009 014 665

## Description

### Technical Field

The present invention relates to a substrate positioning device and a substrate positioning method for determining a placement position of a substrate, such as a glass substrate used in a solar battery, on a placing table.

### Background Art

When a solar battery or the like is manufactured by placing a substrate on a placing table and performing various manufacturing processes on the substrate, there is a great necessity that the substrate be accurately positioned and placed on the placing table.

For example, when a substrate is a glass substrate for a thin-film solar battery, the glass substrate needs to be accurately positioned and disposed on a placing table prior to a process for an electrode in which a power collection electrode is joined on the glass substrate.

As such technology for positioning a glass substrate described above, for example, WO 2009 / 119 772 A1 discloses a method and an apparatus for machining a glass substrate.
JP2006 - 344 675 A discloses a method and a device or positioning a substrate, in advance of the formation of a high-definition pattern on a substrate, such as glass plate for example, without deforming the substrate.
JP 2003 - 229 470 A discloses a preliminary positioning mechanism and a method therefor, capable of performing appropriate preliminary positioning work for substrates of a super thin plate to a thick plate regardless of the thickness of the substrate.

### Summary

### Problem to be Solved by the Invention

The conventional substrate positioning technology disclosed in WO 2009 / 119 772 A1, for example, at the time of substrate positioning in a substrate widthwise direction of a substrate, positioning is performed in consideration of a maximum substrate width error of a substrate width of a substrate to be manufactured. Therefore, the position of the substrate is inevitably shifted by an amount corresponding to an error of the substrate width.

For example, when there is an error of "600 ± 0.8" (mm) in a substrate width, in consideration of a maximum value of the error, positioning is performed assuming that the substrate width is 600.8 mm. Therefore, when an actual substrate width is a minimum value of 599.2 mm, the position is inevitably shifted by 1.6 (= 600.8 - 599.2) mm.

There has been a problem in that an electrode cannot be formed with the above-mentioned electrode position accuracy being satisfied at the same time in an electrode manufacturing process. Specifically, such a problem occurs when a substrate is a glass substrate for a thin-film solar battery, and an electrode is formed with a substrate width center of a substrate being used as a reference and required electrode position accuracy is finer than 1.6 mm described above in an electrode manufacturing process in which a power collection electrode is joined on the glass substrate.

Note that, when an electrode is disposed with an end portion of a glass substrate being used as a reference in the electrode manufacturing process described above, the glass substrate is only required to be pressed toward a fixed reference side to enable disposition of an electrode with mechanical dimensional accuracy. In contrast, when an electrode is disposed with a center of a glass substrate being used as a reference, dimensional accuracy of a substrate width of a substrate directly affects center position accuracy of the glass substrate, which causes a problem in that an electrode cannot be formed with the above-mentioned electrode position accuracy being satisfied at the same time as described above.

In the technology disclosed in WO 2009 / 119 772 A1, a substrate width of a glass substrate is measured prior to machining to perform subsequent machining. Because the glass substrate is positioned with its one end portion being used as a reference, the problem described above cannot be solved when a manufacturing process needs to be performed with a substrate width center of the glass substrate being used as a reference.

The present invention has an object to provide a substrate positioning device capable of solving the problems as described above, and implementing positioning of a substrate at a center position with a relatively simple configuration.

### Means to Solve the Problem

The present invention is intended for a substrate positioning device that positions a substrate having a rectangular planar shape defined by a first direction and a second direction orthogonal to the first direction. The substrate positioning device positions the substrate in a position adjustment direction being one direction out of the first and second directions. The substrate positioning device includes a placing table, first and second positioning mechanisms, and a controller. On the placing table, the substrate is placed. The first and second positioning mechanisms are arranged to face each other along the position adjustment direction with respect to the substrate placed on the placing table, and to be located on both sides of the substrate. The controller is provided for control of the first and second positioning mechanisms. The first positioning mechanism includes a first fixing part, a first extendible and retractable part, and a first tip end part. The first fixing part is fixedly arranged at a first fixing position with respect to the placing table. The first extendible and retractable part is connected to the first fixing part in an extendible and retractable manner, and is configured to perform first extension and retraction operation of extending and retracting along the position adjustment direction. The first tip end part is connected to be coupled to the first extendible and retractable part. A position of the first tip end part in the position adjustment direction is changed toward one movement direction side corresponding to a direction toward the second positioning mechanism during extension in the first extension and retraction operation. A position of the first tip end part in the position adjustment direction is changed toward another movement direction side corresponding to a direction away from the second positioning mechanism during retraction in the first extension and retraction operation. After the first tip end part comes in contact with one end portion of the substrate during extension in the first extension and retraction operation, the first positioning mechanism exerts a first substrate moving force of moving the substrate in the one movement direction side. The second positioning mechanism includes a second fixing part, a second extendible and retractable part, and a second tip end part. The second fixing part is fixedly arranged at a second fixing position with respect to the placing table. The second extendible and retractable part is connected to the second fixing part in an extendible and retractable manner, and is configured to perform second extension and retraction operation of extending and retracting along the position adjustment direction. The second tip end part is connected to the second extendible and retractable part. A position of the second tip end part in the position adjustment direction is changed toward the another movement direction side corresponding to a direction toward the first positioning mechanism during extension in the second extension and retraction operation. A position of the second tip end part in the position adjustment direction is changed toward the one movement direction side corresponding to a direction away from the first positioning mechanism during retraction in the second extension and retraction operation. After the second tip end part comes in contact with another end portion of the substrate during extension in the second extension and retraction operation, the second positioning mechanism exerts a second substrate moving force of moving the substrate in the another movement direction side. The controller recognizes first and second extension and retraction states of the first and second extendible and retractable parts, and simultaneously causes the first and second extension and retraction operations to be executed, and the controller thereby executes positioning control operation so that a center position of the substrate matches a center position of the placing table, in the position adjustment direction.

### Effects of the Invention

According to the substrate positioning device of the present invention, positioning control operation can be accurately executed with a relatively simple configuration, and through relatively simple processing without the necessity of a dedicated sensor. The relatively simple configuration refers to a configuration including main configuration parts of the first and second positioning mechanisms arranged to face each other along the position adjustment direction, and to be located on both sides of the substrate. The relatively simple processing refers to processing in which the first and second extension and retraction states of the first and second extendible and retractable parts are recognized.

These and other objects, features, aspects and advantages of the present invention will become more apparent from the following detailed description of the present invention when taken in conjunction with the accompanying drawings.

### Brief Description of Drawings

FIG. 1 is an explanatory diagram schematically illustrating a configuration of a substrate positioning device as an embodiment of the present invention.
FIG. 2 is a (first) explanatory diagram illustrating details of processing of a substrate positioning method using the substrate positioning device.
FIG. 3 is a (second) explanatory diagram illustrating details of processing of the substrate positioning method using the substrate positioning device.
FIG. 4 is a (third) explanatory diagram illustrating details of processing of the substrate positioning method using the substrate positioning device.
FIG. 5 is a (fourth) explanatory diagram illustrating details of processing of the substrate positioning method using the substrate positioning device.
FIG. 6 is a (fifth) explanatory diagram illustrating details of processing of the substrate positioning method using the substrate positioning device.
FIG. 7 is a flowchart illustrating a procedure of processing of the substrate positioning method using the substrate positioning device of this embodiment.

### Description of Embodiment

### <Embodiment>

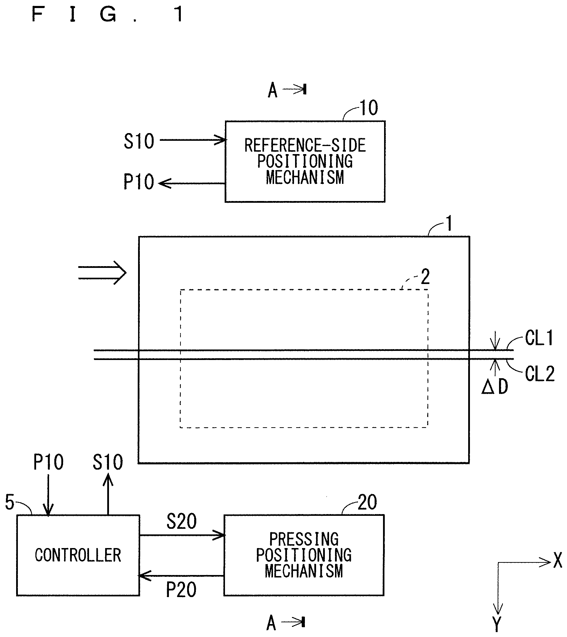

FIG. 1 is an explanatory diagram schematically illustrating a configuration of a substrate positioning device as an embodiment of the present invention. Note that, in FIG. 1, an XY orthogonal coordinate system is illustrated.

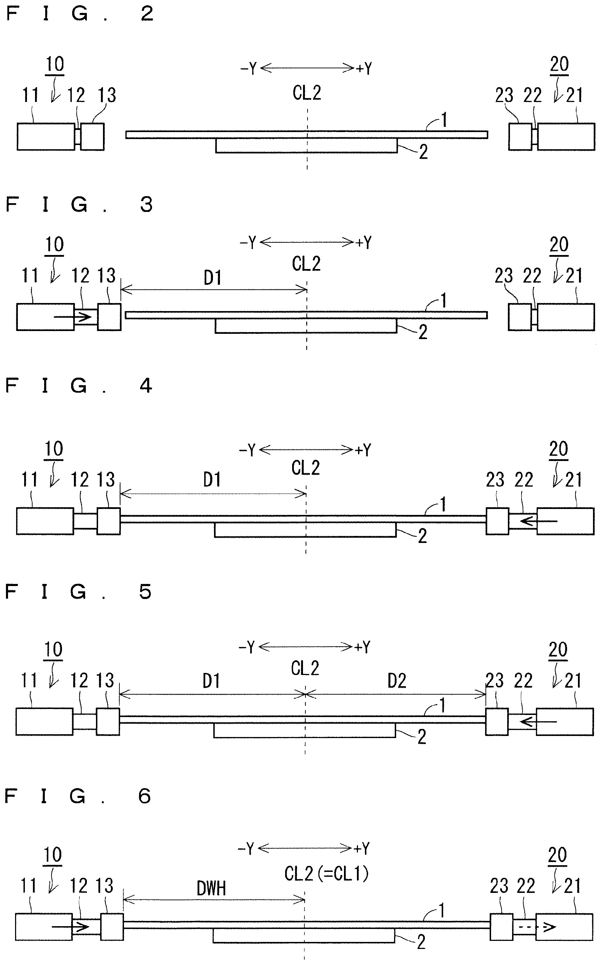

FIG. 2 to FIG. 6 are (first to fifth) explanatory diagrams illustrating details of processing of a substrate positioning method using the substrate positioning device. FIG. 2 to FIG. 6 correspond to cross-sections taken along the line A-A of FIG. 1.

As illustrated in these figures, the substrate positioning device of this embodiment is a device that positions a substrate 1 having a rectangular planar shape defined by an X direction (first direction) and a Y direction (second direction) orthogonal to the X direction. The substrate positioning device of this embodiment positions the substrate 1 by using the Y direction as a position adjustment direction.

The substrate positioning device of this embodiment includes a placing table 2, a controller 5, a reference-side positioning mechanism 10, and a pressing positioning mechanism 20.

The substrate 1 is placed on an upper surface of the placing table 2. The substrate 1 is placed on the placing table 2 so that a longitudinal direction of the substrate 1 corresponds to the X direction, and a widthwise direction corresponds to the Y direction.

The reference-side positioning mechanism 10 and the pressing positioning mechanism 20 are arranged to face each other along the Y direction (position adjustment direction) with respect to the substrate 1 placed on the placing table 2, and to be located on both sides of the substrate 1.

The controller 5 executes and controls positioning control operation by using the reference-side positioning mechanism 10 and the pressing positioning mechanism 20.

As illustrated in FIG. 2 to FIG. 6, the reference-side positioning mechanism 10 being a first positioning mechanism includes a base body part 11, an extendible and retractable part 12, and a tip end part 13.

The base body part 11 being a first fixing part is fixedly arranged at a first fixing position with respect to the placing table 2. Specifically, the base body part 11 is fixedly arranged to be spaced apart by a predetermined distance on a -Y direction side along the Y direction with respect to a placing table center line CL2 of the placing table 2.

The extendible and retractable part 12 being a first extendible and retractable part is connected to the base body part 11 in an extendible and retractable manner, and performs first extension and retraction operation of extending and retracting along the Y direction.

The tip end part 13 being a first tip end part is connected to be coupled to the extendible and retractable part 12. The position of the tip end part 13 in the Y direction is changed toward a +Y direction (one movement direction) side corresponding to a direction toward the pressing positioning mechanism 20 during extension of the extendible and retractable part 12 in the first extension and retraction operation. The position of the tip end part 13 in the Y direction is changed toward the -Y direction (another movement direction) side corresponding to a direction away from the pressing positioning mechanism 20 during retraction in the first extension and retraction operation.

Therefore, after the tip end part 13 comes in contact with one end portion (left end portion illustrated in FIG. 2 to FIG. 6) of the substrate 1 during extension of the extendible and retractable part 12 in the first extension and retraction operation, the reference-side positioning mechanism 10 exerts a first substrate moving force of moving the substrate 1 in the +Y direction side.

Note that examples of the first extension and retraction operation of the extendible and retractable part 12 include extending and retracting operation achieved by a ball screw using a drive source such as a servomotor and a step motor.

The pressing positioning mechanism 20 being a second positioning mechanism includes a base body part 21, an extendible and retractable part 22, and a tip end part 23.

The base body part 21 being a second fixing part is fixedly arranged at a second fixing position with respect to the placing table 2. Specifically, the base body part 21 is fixedly arranged to be spaced apart by a predetermined distance on the +Y direction side along the Y direction with respect to the placing table center line CL2 of the placing table 2.

The extendible and retractable part 22 being a second extendible and retractable part is connected to the base body part 21 in an extendible and retractable manner, and performs second extension and retraction operation of extending and retracting along the Y direction.

The tip end part 23 being a second tip end part is connected to be coupled to the extendible and retractable part 22. The position of the tip end part 23 in the Y direction is changed toward the -Y direction (another movement direction) side corresponding to a direction toward the reference-side positioning mechanism 10 during extension of the extendible and retractable part 22 in the second extension and retraction operation. The position of the tip end part 23 in the Y direction is changed toward the +Y direction (one movement direction) side corresponding to a direction away from the reference-side positioning mechanism 10 during retraction in the second extension and retraction operation.

Therefore, after the tip end part 23 comes in contact with another end portion (right end portion illustrated in FIG. 2 to FIG. 6) of the substrate 1 during extension of the extendible and retractable part 22 in the second extension and retraction operation, the pressing positioning mechanism 20 exerts a second substrate moving force of moving the substrate 1 in the -Y direction side.

Note that examples of the extendible and retractable part 22 include an air cylinder.

The controller 5 receives extension and retraction information P10 and extension and retraction information P20 for commanding first and second extension and retraction states of the extendible and retractable parts 12 and 22 from the reference-side positioning mechanism 10 and the pressing positioning mechanism 20. Therefore, based on the extension and retraction information P10, the controller 5 can recognize a first extension and retraction state, which is an extension and retraction state of the extendible and retractable part 12 of the reference-side positioning mechanism 10. Based on the extension and retraction information P20, the controller 5 can recognize an extension and retraction state, which is an extension and retraction state of the extendible and retractable part 22 of the pressing positioning mechanism 20.

The controller 5 recognizes the first and second extension and retraction states, and simultaneously gives control signals S10 and S20 to the reference-side positioning mechanism 10 and the pressing positioning mechanism 20 to cause the first and second extension and retraction operations to be appropriately executed. The controller 5 thereby executes the positioning control operation so that a substrate center line CL1 indicating a center position of the substrate 1 matches the placing table center line CL2 indicating a center position of the placing table 2, in the Y direction being the position adjustment direction.

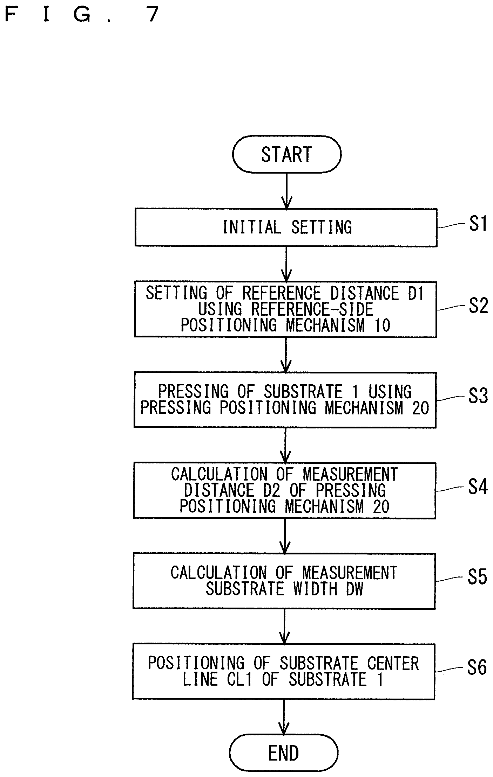

FIG. 7 is a flowchart illustrating a procedure of processing of the substrate positioning method using the substrate positioning device of this embodiment. With reference to FIG. 7 as well as to FIG. 1 to FIG. 6 as appropriate, the details of processing of the substrate positioning method will be described below.

First, in Step S1, initial setting for the substrate positioning device of this embodiment is executed. The initial setting is setting in which the substrate 1 is placed on an upper surface of the placing table 2 so as not to come in contact with the reference-side positioning mechanism 10 and the pressing positioning mechanism 20. Note that the initial setting of Step S1 is implemented by using existing technology.

After execution of Step S1, as illustrated in FIG. 1, the reference-side positioning mechanism 10 and the pressing positioning mechanism 20 being the first and second positioning mechanisms are arranged to face each other along the Y direction being the position adjustment direction, and to be located on both sides of the substrate 1. Specifically, arrangement is performed so that a substrate longitudinal direction of the substrate 1 corresponds to the X direction illustrated in FIG. 1, and a substrate widthwise direction of the substrate 1 corresponds to the Y direction illustrated in FIG. 1.

As illustrated in FIG. 2, during the initial setting, both the first and second extension and retraction states of the extendible and retractable parts 12 and 22 of the reference-side positioning mechanism 10 and the pressing positioning mechanism 20 are most retracted states, and thus the tip end parts 13 and 23 do not come in contact with end portions of the substrate 1.

As illustrated in FIG. 1, after execution of Step S1, there is a high probability that a Y-direction error ΔD is generated between the substrate center line CL1 of the substrate 1 in the substrate widthwise direction (Y direction) and the placing table center line CL2 of the placing table 2 in the Y direction.

In view of this, to bring the Y-direction error ΔD to "0," the substrate positioning device of this embodiment executes the processing of Steps S2 to S6 described below as the positioning control operation performed under the control of the controller 5. The controller 5 recognizes the first and second extension and retraction states of the extendible and retractable parts 12 and 22 based on the extension and retraction information P10 and the extension and retraction information P20, and simultaneously outputs the control signals S10 and S20 to the reference-side positioning mechanism 10 and the pressing positioning mechanism 20 to cause the first and second extension and retraction operations to be appropriately executed. The controller 5 thereby executes a measurement distance D2 and the positioning control operation.

First, in Step S2 executed after Step S1, the controller 5 causes the extendible and retractable part 12 to execute the first extension and retraction operation (extension operation). After the controller 5 causes the extension and retraction state of the extendible and retractable part 12 to be a reference extension and retraction state, the controller 5 stops the first extension and retraction operation and sets to a reference arrangement state. As a result, as illustrated in FIG. 3, reference positioning setting is performed so that a distance from the placing table center line CL2 of the placing table 2 to the tip end part 13 is equal to a reference distance D1.

The extension and retraction state of the extendible and retractable part 12 refers to an extension and retraction length of the extendible and retractable part 12 (distance between the base body part 11 and the tip end part 13). The reference extension and retraction state refers to a state in which the extension and retraction length of the extendible and retractable part 12 is equal to a predetermined reference length.

A distance between the base body part 11 and the placing table center line CL2 is predetermined. Therefore, by setting the extension and retraction state of the extendible and retractable part 12 to the reference extension and retraction state, a distance from the placing table center line CL2 to the tip end part 13 can be securely set to the reference distance D1. Note that, for example, if a designed dimension of a substrate width of the substrate 1 is 660 (mm), the reference distance D1 may be 330 (mm), which is half the designed dimension.

Note that FIG. 3 illustrates a state out of contact with one end portion (left end portion in FIG. 3) of the substrate 1 during the reference arrangement state of the extendible and retractable part 12 of the reference-side positioning mechanism 10. In contrast, one end portion of the substrate 1 may be present at a position beyond the reference distance D1 from the placing table center line CL2 during an initial state illustrated in FIG. 2. In this case, the tip end part 13 comes in contact with one end portion of the substrate 1 during execution of the first extension and retraction operation (extension operation) of the extendible and retractable part 12. After that, the first substrate moving force of moving the substrate 1 toward the +Y direction side is exerted. Therefore, the substrate 1 is moved so that one end portion of the substrate 1 is located at a position of the reference distance D1 from the placing table center line CL2 during execution of the first extension and retraction operation (extension operation) of the extendible and retractable part 12.

After that, in Step S3 executed after Step S2, as illustrated in FIG. 4, the controller 5 causes the extendible and retractable part 22 of the pressing positioning mechanism 20 to execute the second extension and retraction operation (extension operation), and thereby executes pressing processing of the substrate 1.

As a result of the pressing processing of the substrate performed by the pressing positioning mechanism 20, finally, the tip end part 13 comes in contact with one end portion (left end portion in FIG. 4) of the substrate 1, and the tip end part 23 comes in contact with another end portion (right end portion in FIG. 4) of the substrate 1. Note that the second extension and retraction operation (extension operation) of the pressing positioning mechanism 20 is caused to continue even after execution of Step S3.

Specifically, in Step S3, when the controller 5 causes the extendible and retractable part 22 to execute the second extension and retraction operation (extension operation), the tip end part 23 comes in contact with another end portion of the substrate 1. After that, a second substrate moving force of moving the substrate 1 toward the -Y direction side is exerted. This moves the substrate 1 in the -Y direction, and the tip end part 13 finally comes in contact with one end portion of the substrate 1.

When the base body part 11 is in contact with one end portion of the substrate 1 during the reference arrangement state, the reference-side positioning mechanism 10 exerts a substrate position maintaining force of maintaining the position of the substrate 1. The substrate position maintaining force is set to be larger than the second substrate moving force of the pressing positioning mechanism 20.

Therefore, when the position of the substrate 1 is maintained due to the substrate position maintaining force of the reference-side positioning mechanism 10, the position of the substrate 1 in the Y direction is not changed, irrespective of whether or not the second extension and retraction operation (extension operation) of the pressing positioning mechanism 20 is performed, i.e., even when the pressing positioning mechanism 20 continuously executes the second extension and retraction operation (extension operation). In this manner, due to the substrate position maintaining force of the reference-side positioning mechanism 10, the substrate 1 can be stably maintained so that one end portion of the substrate 1 is located at a distance of the reference distance D1 from the placing table center line CL2.

Moreover, after execution of Step S2, Step S3 may be executed while one end portion of the substrate 1 is already in contact with the tip end part 13 of the reference-side positioning mechanism 10. In this case, when the tip end part 23 comes in contact with another end portion of the substrate 1 due to the second extension and retraction operation (extension operation) of the extendible and retractable part 22, the position of the substrate 1 is thereafter maintained due to the substrate position maintaining force of the reference-side positioning mechanism 10. Therefore, the processing of Step S3 substantially ends.

In Step S4 executed after Step S3, as illustrated in FIG. 5, the controller 5 calculates a distance from the placing table center line CL2 to the tip end part 23 as the measurement distance D2, based on the extension and retraction state of the extendible and retractable part 22 of the pressing positioning mechanism 20 recognized with reference to the extension and retraction information P20.

The extension and retraction state of the extendible and retractable part 22 refers to an extension and retraction length of the extendible and retractable part 22 (distance between the base body part 21 and the tip end part 23). A distance between the base body part 21 and the placing table center line CL2 is predetermined. Therefore, the measurement distance D2 being a distance from the placing table center line CL2 to the tip end part 23 can be accurately calculated, based on the extension and retraction state of the extendible and retractable part 22.

After that, in Step S5, the controller 5 calculates a measurement substrate width DW (measurement substrate formation length) being a formation length of the substrate 1 in a direction matching the Y direction being the position adjustment direction, based on the reference distance D1 and the measurement distance D2. The measurement substrate width DW is equal to the sum of the reference distance D1 and the measurement distance D2.

Finally, in Step S6, as illustrated in FIG. 6, based on the measurement substrate width DW, the controller 5 causes the extendible and retractable parts 12 and 22 to execute the first and second extension and retraction operations so that the substrate center line CL1 of the substrate 1 matches the placing table center line CL2 of the placing table 2. In this manner, the controller 5 performs positioning processing of the substrate center line CL1 of the substrate 1.

A first case will be discussed below. In the first case, for example, the reference distance D1 is 330 (mm) and the measurement distance D2 is 327 (mm). In the first case, in Step S5, the measurement substrate width DW is calculated as 657 (mm) (= 330 + 327 (mm)), and thus a 1/2 substrate width DWH is 328.5 (mm) (657/2 (mm)).

Therefore, the controller 5 can recognize that the position of the substrate 1 is shifted from the placing table center line CL2 toward the -Y direction side by 1.5 mm (= 330 - 328.5 (mm)).

Therefore, in Step S6, as illustrated in FIG. 6, the controller 5 causes the extendible and retractable part 12 of the reference-side positioning mechanism 10 to execute the first extension and retraction operation (extension operation). After the controller 5 causes the extension and retraction state of the extendible and retractable part 12 to be extended from the reference length by 1.5 mm, the controller 5 stops the first extension and retraction operation, and causes the reference-side positioning mechanism 10 to exert the substrate position maintaining force again.

In this case, the first substrate moving force of the reference-side positioning mechanism 10 is set to be larger than the second substrate moving force of the pressing positioning mechanism 20. Therefore, even in a state in which the pressing positioning mechanism 20 continuously executes the second extension and retraction operation (extension operation), the substrate 1 can be moved toward the +Y direction side by 1.5 mm due to the first extension and retraction operation (extension operation) of the reference-side positioning mechanism 10.

As a result, as illustrated in FIG. 6, substrate positioning processing of correcting the Y-direction error ΔD generated during the initial setting state of FIG. 1, and positioning the substrate center line L1 and the placing table center line CL2 is completed. After completion of the substrate positioning processing, under the control of the controller 5, the first and second extension and retraction operations are temporarily stopped. Then, the first and second extension and retraction operations (both are retraction operations) are executed, and the substrate 1 is released from the reference-side positioning mechanism 10 and the pressing positioning mechanism 20.

In this manner, the first substrate moving force is set to be larger than the second substrate moving force between the reference-side positioning mechanism 10 and the pressing positioning mechanism 20. Therefore, even in a state in which the pressing positioning mechanism 20 exerts the second substrate moving force, the substrate 1 can be smoothly moved toward the +Y direction (one movement direction) side due to the first substrate moving force of the reference-side positioning mechanism 10.

Therefore, according to the substrate positioning device of this embodiment, the substrate 1 can be moved toward the +Y direction side due to the first substrate moving force of the reference-side positioning mechanism 10, irrespective of whether or not the second extension and retraction operation of the pressing positioning mechanism 20 is performed. Consequently, the positioning control operation can be simplified.

As such simplified positioning control operation, for example, there is an operation in which extension operation of the second extension and retraction operation of the pressing positioning mechanism 20 is only necessary to be continuously executed in Steps S3 to S6.

Next, a second case will be discussed below. In the second case, for example, the reference distance D1 is 330 (mm) and the measurement distance D2 is 333 (mm). In the second case, in Step S5, the measurement substrate width DW is calculated as 663 (mm) (= 330 + 333 (mm)), and thus the 1/2 substrate width DWH is 331.5 (mm).

Therefore, the controller 5 can recognize that the position of the substrate 1 is shifted from the placing table center line CL2 toward the +Y direction side by 1.5 mm (= 331.5 - 300 (mm)).

Therefore, in Step S6, the extendible and retractable part 12 of the reference-side positioning mechanism 10 is caused to execute the first extension and retraction operation (retraction operation). After the extension and retraction state of the extendible and retractable part 12 is caused to be retracted from the reference length by 1.5 mm, the first extension and retraction operation (retraction operation) is stopped, and the reference-side positioning mechanism 10 is caused to exert the substrate position maintaining force again.

As a result, due to the continuously executed second extension and retraction operation (extension operation) of the pressing positioning mechanism 20, the substrate 1 can be moved toward the -Y direction side by 1.5 mm, and the substrate center line CL1 and the placing table center line CL2 can be positioned.

In this manner, according to the substrate positioning device of this embodiment, the positioning control operation can be accurately executed with a relatively simple configuration. The relatively simple configuration refers to a configuration including main drive parts of the reference-side positioning mechanism 10 and the pressing positioning mechanism 20 arranged to face each other along the Y direction being the position adjustment direction, and to be located on both sides of the substrate 1.

Moreover, according to the substrate positioning device of this embodiment, the positioning control operation can be accurately executed through a series of relatively simple processing (S2 to S6) without the necessity of a dedicated sensor. The relatively simple processing refers to processing in which the first and second extension and retraction states of the extendible and retractable parts 12 and 22 are recognized based on the extension and retraction information P10 and the extension and retraction information P20.

In addition, according to the substrate positioning method executed using the substrate positioning device of this embodiment, the most part of the processing (Steps S2 to S6), except Step S1, is executed as the positioning control operation of the controller 5. Consequently, after the initial setting of Step S1, the substrate positioning processing can be automatically performed by the substrate positioning device of this embodiment.

Note that examples of the substrate 1 include a glass substrate for a solar battery.

When such a glass substrate is used in a solar battery whose electrode is formed with the center of the glass substrate being used as a reference, the glass substrate placed on the placing table 2 is positioned so that a center position of the glass substrate matches a center position of the placing table by the substrate positioning device of this embodiment. In this manner, the solar battery can be manufactured with its electrode accurately formed on the glass substrate.

### <Additional Notes>

Note that, in the substrate positioning device of this embodiment, the Y direction being the substrate widthwise direction of the substrate 1 is used as the position adjustment direction. However, there may be another mode in which the X direction being the substrate longitudinal direction of the substrate 1 is used as the position adjustment direction.

In such another mode, the reference-side positioning mechanism 10 and the pressing positioning mechanism 20 are arranged to face each other along the X direction (position adjustment direction) with respect to the substrate 1 placed on the placing table 2, and to be located on both sides of the substrate 1.

The controller 5 uses the reference-side positioning mechanism 10 and the pressing positioning mechanism 20 to execute and control the positioning control operation so that the center position (center position in the substrate longitudinal direction) of the substrate 1 matches the center position of the placing table 2, in the X direction.

While the invention has been shown and described in detail, the foregoing description is in all aspects illustrative and not restrictive. It is therefore understood that numerous unillustrated modifications and variations can be devised without departing from the scope of the invention which is defined by the appended claims.

### Explanation of Reference Signs

- 1: substrate
- 2: placing table
- 5: controller
- 10: reference-side positioning mechanism
- 11, 21: base body part
- 12, 22: extendible and retractable part
- 13, 23: tip end part
- 20: pressing positioning mechanism

## Claims

1. A substrate positioning device that positions a substrate (1) having a rectangular planar shape defined by a first direction and a second direction orthogonal to said first direction, said substrate positioning device positioning said substrate in a position adjustment direction being one direction out of said first and second directions, said substrate positioning device comprising:
a placing table (2) on which said substrate is placed;
first and second positioning mechanisms (10, 20) arranged to face each other along said position adjustment direction with respect to said substrate placed on said placing table, and to be located on both sides of said substrate; and
a controller (5) provided for control of said first and second positioning mechanisms, wherein
said first positioning mechanism (10) includes:
a first fixing base body part (11) fixedly arranged at a first fixing position with respect to said placing table;
a first extendible and retractable part (12) being connected to said first fixing base body part in an extendible and retractable manner, and being configured to perform first extension and retraction operation of extending and retracting along said position adjustment direction; and
a first tip end part (13) being connected to be coupled to said first extendible and retractable part, a position of said first tip end part in said position adjustment direction being changed toward one movement direction side corresponding to a direction toward said second positioning mechanism during extension in said first extension and retraction operation, a position of said first tip end part in said position adjustment direction being changed toward another movement direction side corresponding to a direction away from said second positioning mechanism during retraction in said first extension and retraction operation,
after said first tip end part comes in contact with one end portion of said substrate during extension in said first extension and retraction operation, said first positioning mechanism exerts a first substrate moving force of moving said substrate in said one movement direction side,
said second positioning mechanism (20) includes:
a second fixing base body part (21) fixedly arranged at a second fixing position with respect to said placing table;
a second extendible and retractable part (22) being connected to said second fixing base body part in an extendible and retractable manner, and being configured to perform second extension and retraction operation of extending and retracting along said position adjustment direction; and
a second tip end part (23) being connected to said second extendible and retractable part, a position of said second tip end part in said position adjustment direction being changed toward said another movement direction side corresponding to a direction toward said first positioning mechanism during extension in said second extension and retraction operation, a position of said second tip end part in said position adjustment direction being changed toward said one movement direction side corresponding to a direction away from said first positioning mechanism during retraction in said second extension and retraction operation,
after said second tip end part comes in contact with another end portion of said substrate during extension in said second extension and retraction operation, said second positioning mechanism exerts a second substrate moving force of moving said substrate in said another movement direction side,
said controller recognizes first and second extension and retraction states of said first and second extendible and retractable parts, and simultaneously causes said first and second extension and retraction operations to be executed, and said controller thereby executes positioning control operation so that a center position (CL1) of said substrate matches a center position (CL2) of said placing table, in said position adjustment direction,
when said first tip end part is in contact with one end portion of said substrate during a reference arrangement state, said first positioning mechanism exerts a substrate position maintaining force of maintaining a position of said substrate, said reference arrangement state being a state in which said first extension and retraction state of said first extendible and retractable part is caused to be a reference extension and retraction state, and in which said first extension and retraction operation is stopped, and
said substrate position maintaining force is larger than said second substrate moving force exerted by said second positioning mechanism.

2. The substrate positioning device according to claim 1, wherein
said first substrate moving force is larger than said second substrate moving force.

3. The substrate positioning device according to claim 1 or 2, wherein
said substrate includes a glass substrate for a solar battery.

4. A substrate positioning method of positioning a substrate (1) using said substrate positioning device of any one of claims 1 to 3, said substrate positioning method comprising the steps of:
(a) performing initial setting for said substrate positioning device, said initial setting being setting in which said substrate is placed on said placing table (2) so as not to come in contact with said first and second positioning mechanisms (10, 20), wherein after execution of said step (a), said first and second positioning mechanisms are arranged to face each other along said position adjustment direction, and to be located on both sides of said substrate,
the substrate positioning method further comprises the steps of:
(b) after execution of said step (a), causing said first extendible and retractable part (12) to execute said first extension and retraction operation, and after causing a first extension and retraction state of said first extendible and retractable part to be said reference extension and retraction state, stopping said first extension and retraction operation and setting to said reference arrangement state, so that a distance from a center of said placing table to said first tip end part (13) is equal to a reference distance (D1);
(c) after execution of said step (b), causing said second extendible and retractable part (22) to execute said second extension and retraction operation, so that said first tip end part comes in contact with one end portion of said substrate, and said second tip end part (23) comes in contact with another end portion of said substrate;
(d) after execution of said step (c), calculating a distance from the center of said placing table to said second tip end part as a measurement distance (D2), based on a second extension and retraction state of said second extendible and retractable part;
(e) calculating a formation length of said substrate in a direction matching said position adjustment direction out of said first and second directions as a measurement substrate formation length (DW), based on said reference distance and said measurement distance; and
(f) based on said measurement substrate formation length, causing said first and second extension and retraction operations so that the center (CL1) of said substrate matches the center (CL2) of said placing table, and
said steps (b) to (f) are executed as said positioning control operation of said controller (5).

## Patentansprüche

1. Substratpositioniervorrichtung, die ein Substrat (1) mit einer rechteckigen ebenen Form, welche durch eine erste Richtung und eine zweite Richtung orthogonal zu der ersten Richtung definiert ist, positioniert, wobei die Substratpositioniervorrichtung das Substrat in einer Positionseinstellrichtung positioniert, die eine Richtung aus der ersten und der zweiten Richtung ist, wobei die Substratpositioniervorrichtung beinhaltet:
einen Platzierungstisch (2), auf dem das Substrat platziert ist;
einen ersten und einen zweiten Positionierungsmechanismus (10, 20), die so angeordnet sind, dass sie sich in der Positionseinstellrichtung in Bezug auf das auf dem Platzierungstisch platzierte Substrat gegenüberliegen und sich auf beiden Seiten des Substrats befinden; und
eine Steuereinheit (5), die zur Steuerung des ersten und des zweiten Positionierungsmechanismus vorgesehen ist,
wobei der erste Positionierungsmechanismus (10) beinhaltet:
einen ersten Befestigungsgrundkörper (11), der fest in einer ersten Befestigungsposition in Bezug auf den Platzierungstisch angeordnet ist;
ein erstes ausfahrbares und einziehbares Teil (12), das mit dem ersten Befestigungsgrundkörper in einer ausfahrbaren und einziehbaren Weise verbunden ist und so konfiguriert ist, dass es einen ersten Ausfahr- und Einziehvorgang des Ausfahrens und Einziehens in der Positionseinstellrichtung durchführt; und
ein erstes Spitzenendteil (13), das so verbunden ist, dass es mit dem ersten ausfahrbaren und einziehbaren Teil gekoppelt ist, wobei eine Position des ersten Spitzenendteils in der Positionseinstellrichtung zu einer Bewegungsrichtungsseite während des Ausfahrens bei dem ersten Ausfahr- und Einziehvorgang hin geändert wird, die einer Richtung zu dem zweiten Positionierungsmechanismus hin entspricht, wobei eine Position des ersten Spitzenendteils während des Einziehens bei dem ersten Ausfahr- und Einziehvorgang in der Positionseinstellrichtung zu einer anderen Bewegungsrichtungsseite hin geändert wird, die einer Richtung weg von dem zweiten Positionierungsmechanismus entspricht,
wobei, nachdem das erste Spitzenendteil mit einem Endabschnitt des Substrats während des Ausfahrens in dem ersten Ausfahr- und Einziehvorgang in Kontakt kommt, der erste Positionierungsmechanismus eine erste Substratbewegungskraft zum Bewegen des Substrats in die eine Bewegungsrichtungsseite ausübt,
wobei der zweite Positionierungsmechanismus (20) beinhaltet:
einen zweiten Befestigungsgrundkörper (21), der fest in einer zweiten Befestigungsposition in Bezug auf den Platzierungstisch angeordnet ist;
ein zweites ausfahrbares und einziehbares Teil (22), das mit dem zweiten Befestigungsgrundkörper ausfahrbar und einziehbar verbunden ist und so konfiguriert ist, dass es einen zweiten Ausfahr- und Einziehvorgang des Ausfahrens und Einziehens entlang der Positionseinstellrichtung durchführt; und
ein zweites Spitzenendteil (23), das mit dem zweiten ausfahrbaren und einziehbaren Teil verbunden ist, wobei eine Position des zweiten Spitzenendteils in der Positionseinstellrichtung während des Ausfahrens bei dem zweiten Ausfahr- und Einziehvorgang zu der anderen Bewegungsrichtungsseite hin geändert wird, die einer Richtung hin zu dem ersten Positionierungsmechanismus entspricht, wobei eine Position des zweiten Spitzenendteils in der Positionseinstellrichtung während des Einziehens bei dem zweiten Ausfahr- und Einziehvorgang zu der einen Bewegungsrichtungsseite hin geändert wird, die einer Richtung von dem ersten Positionierungsmechanismus weg entspricht,
wobei, nachdem das zweite Spitzenendteil mit einem anderen Endabschnitt des Substrats während des Ausfahrens in dem zweiten Ausfahr- und Einziehvorgang in Kontakt kommt, der zweite Positionierungsmechanismus eine zweite Substratbewegungskraft ausübt, um das Substrat in die andere Bewegungsrichtungsseite zu bewegen,
wobei die Steuereinheit einen ersten und einen zweiten Ausfahr- und Einziehzustand des ersten und des zweiten ausfahrbaren und einziehbaren Teils erkennt und gleichzeitig bewirkt, dass der erste und der zweite Ausfahr- und Einziehvorgang ausgeführt werden, und die Steuereinheit dadurch einen Positionierungssteuerungsvorgang ausführt, so dass eine Mittelposition (CL1) des Substrats mit einer Mittelposition (CL2) des Platzierungstisches in der Positionseinstellungsrichtung übereinstimmt,
wobei, wenn das erste Spitzenendteil mit einem Endabschnitt des Substrats während eines Referenzanordnungszustands in Kontakt ist, der erste Positionierungsmechanismus eine Substratpositionshaltekraft zum Halten einer Position des Substrats ausübt, wobei der Referenzanordnungszustand ein Zustand ist, in dem der erste Ausfahr- und Einziehzustand des ersten ausfahrbaren und einziehbaren Teils veranlasst wird, ein Referenzausfahr- und -einziehzustand zu sein, und in dem der erste Ausfahr- und Einziehvorgang gestoppt wird, und
wobei die Substratpositionshaltekraft größer ist als die zweite Substratbewegungskraft, die durch den zweiten Positionierungsmechanismus ausgeübt wird.

2. Substratpositioniervorrichtung nach Anspruch 1, wobei die erste Substratbewegungskraft größer ist als die zweite Substratbewegungskraft.

3. Substratpositioniervorrichtung nach Anspruch 1 oder 2, wobei das Substrat ein Glassubstrat für eine Solarbatterie enthält.

4. Substratpositionierungsverfahren zum Positionieren eines Substrats (1) unter Verwendung der Substratpositionierungsvorrichtung nach einem der Ansprüche 1 bis 3, wobei das Substratpositionierungsverfahren die folgenden Schritte beinhaltet:
(a) Durchführen einer Anfangseinstellung für die Substratpositionierungsvorrichtung, wobei die Anfangseinstellung eine Einstellung ist, bei der das Substrat auf dem Platzierungstisch (2) platziert ist, so dass es nicht in Kontakt mit dem ersten und zweiten Positionierungsmechanismus (10, 20) kommt, wobei nach Ausführung des Schritts (a) der erste und der zweite Positionierungsmechanismus so angeordnet sind, dass sie sich entlang der Positionseinstellrichtung gegenüberstehen und sich auf beiden Seiten des Substrats befinden,
wobei das Verfahren zur Positionierung des Substrats ferner die folgenden Schritte beinhaltet:
(b) nach der Ausführung des Schritts (a), Bewirken, dass das erste ausfahrbare und einziehbare Teil (12) den ersten Ausfahr- und Einziehvorgang ausführt, und nach dem Bewirken, dass ein erster Ausfahr- und Einziehzustand des ersten ausfahrbaren und einziehbaren Teils der Referenzausfahr- und -einziehzustand ist, Stoppen des ersten Ausfahr- und Einziehvorgangs und Einstellen auf den Referenzanordnungszustand, so dass ein Abstand von einer Mitte des Platzierungstisches zu dem ersten Spitzenendteil (13) gleich einem Referenzabstand (D1) ist;
(c) nach Ausführung des Schritts (b), Bewirken, dass das zweite ausfahrbare und einziehbare Teil (22) den zweiten Ausfahr- und Einziehvorgang ausführt, so dass das erste Spitzenendteil in Kontakt mit einem Endabschnitt des Substrats kommt und das zweite Spitzenendteil (23) in Kontakt mit einem anderen Endabschnitt des Substrats kommt;
(d) nach Ausführung des Schritts (c), Berechnen eines Abstands von der Mitte des Platzierungstisches zu dem zweiten Spitzenendteil als Messabstand (D2), basierend auf einem zweiten Ausfahr- und Einfahrzustand des zweiten ausfahrbaren und einfahrbaren Teils;
(e) Berechnen einer Ausbildungslänge des Substrats in einer Richtung, die der Positionseinstellrichtung entspricht, aus den ersten und zweiten Richtungen als eine gemessene Substratausbildungslänge (DW), basierend auf dem Referenzabstand und dem Messabstand; und
(f) Veranlassen des ersten und zweiten Ausfahr- und Einfahrvorgangs auf der Grundlage der gemessenen Substratbildungslänge, so dass die Mitte (CL1) des Substrats mit der Mitte (CL2) des Platzierungstisches übereinstimmt, und
wobei die Schritte (b) bis (f) als die Positionierungssteuerungsoperation der Steuereinheit (5) ausgeführt werden.

## Revendications

1. Dispositif de positionnement de substrat qui positionne un substrat (1) présentant une forme plane rectangulaire définie par une première direction et une seconde direction orthogonale à ladite première direction, ledit dispositif de positionnement de substrat positionnant ledit substrat dans une direction d'ajustement de position étant une direction parmi lesdites première et seconde directions, ledit dispositif de positionnement de substrat comprenant :
une table de placement (2) sur laquelle ledit substrat est placé ;
des premier et second mécanismes de positionnement (10, 20) agencés pour se faire face l'un l'autre le long de ladite direction d'ajustement de position par rapport audit substrat placé sur ladite table de placement, et pour être situés des deux côtés dudit substrat ; et
un dispositif de commande (5) prévu pour une commande desdits premier et second mécanismes de positionnement, dans lequel
ledit premier mécanisme de positionnement (10) inclut :
une première partie de corps de base de fixation (11) agencée de manière fixe au niveau d'une première position de fixation par rapport à ladite table de placement ;
une première partie extensible et rétractable (12) étant reliée à ladite première partie de corps de base de fixation d'une manière extensible et rétractable, et étant configurée pour effectuer une première opération d'extension et de rétractation consistant à s'étendre et à se rétracter le long de ladite direction d'ajustement de position ; et
une première partie d'extrémité de pointe (13) étant reliée pour être couplée à ladite première partie extensible et rétractable, une position de ladite première partie d'extrémité de pointe dans ladite direction d'ajustement de position étant modifiée vers un côté de direction de mouvement correspondant à une direction vers ledit second mécanisme de positionnement au cours d'une extension dans ladite première opération d'extension et de rétractation, une position de ladite première partie d'extrémité de pointe dans ladite direction d'ajustement de position étant modifiée vers un autre côté de direction de mouvement correspondant à une direction à l'écart dudit second mécanisme de positionnement au cours d'une rétractation dans ladite première opération d'extension et de rétractation,
après que ladite première partie d'extrémité de pointe vient en contact avec une partie d'extrémité dudit substrat au cours d'une extension dans ladite première opération d'extension et de rétractation, ledit premier mécanisme de positionnement exerce une première force de déplacement de substrat consistant à déplacer ledit substrat dans ledit un côté de direction de mouvement,
ledit second mécanisme de positionnement (20) inclut :
une seconde partie de corps de base de fixation (21) agencée de manière fixe au niveau d'une seconde position de fixation par rapport à ladite table de placement ;
une seconde partie extensible et rétractable (22) étant reliée à ladite seconde partie de corps de base de fixation d'une manière extensible et rétractable, et étant configurée pour effectuer une seconde opération d'extension et de rétractation consistant à s'étendre et à se rétracter le long de ladite direction d'ajustement de position ; et
une seconde partie d'extrémité de pointe (23) étant reliée à ladite seconde partie extensible et rétractable, une position de ladite seconde partie d'extrémité de pointe dans ladite direction d'ajustement de position étant modifiée vers ledit autre côté de direction de mouvement correspondant à une direction vers ledit premier mécanisme de positionnement au cours d'une extension dans ladite seconde opération d'extension et de rétractation, une position de ladite seconde partie d'extrémité de pointe dans ladite direction d'ajustement de position étant modifiée vers ledit un côté de direction de mouvement correspondant à une direction à l'écart dudit premier mécanisme de positionnement au cours d'une rétractation dans ladite seconde opération d'extension et de rétractation,
après que ladite seconde partie d'extrémité de pointe vient en contact avec une autre partie d'extrémité dudit substrat au cours d'une extension dans ladite seconde opération d'extension et de rétractation, ledit second mécanisme de positionnement exerce une seconde force de déplacement de substrat consistant à déplacer ledit substrat dans ledit autre côté de direction de mouvement,
ledit dispositif de commande reconnaît des premier et second états d'extension et de rétractation desdites première et seconde parties extensibles et rétractables, et amène simultanément lesdites première et seconde opérations d'extension et de rétractation à être exécutées, et ledit dispositif de commande exécute ainsi une opération de commande de positionnement de sorte qu'une position centrale (CL1) dudit substrat correspond à une position centrale (CL2) de ladite table de placement, dans ladite direction d'ajustement de position,
lorsque ladite première partie d'extrémité de pointe est en contact avec une partie d'extrémité dudit substrat au cours d'un état d'agencement de référence, ledit premier mécanisme de positionnement exerce une force de maintien de position de substrat consistant à maintenir une position dudit substrat, ledit état d'agencement de référence étant un état dans lequel ledit premier état d'extension et de rétractation de ladite première partie extensible et rétractable est amené à être un état d'extension et de rétractation de référence, et dans lequel ladite première opération d'extension et de rétractation est arrêtée, et
ladite force de maintien de position de substrat est supérieure à ladite seconde force de déplacement de substrat exercée par ledit second mécanisme de positionnement.

2. Dispositif de positionnement de substrat selon la revendication 1, dans lequel
ladite première force de déplacement de substrat est supérieure à ladite seconde force de déplacement de substrat.

3. Dispositif de positionnement de substrat selon la revendication 1 ou 2, dans lequel
ledit substrat inclut un substrat en verre pour une batterie solaire.

4. Procédé de positionnement de substrat consistant à positionner un substrat (1) en utilisant ledit dispositif de positionnement de substrat selon l'une quelconque des revendications 1 à 3, ledit procédé de positionnement de substrat comprenant les étapes consistant à
(a) effectuer un réglage initial pour ledit dispositif de positionnement de substrat, ledit réglage initial étant un réglage dans lequel ledit substrat est placé sur ladite table de placement (2) de manière à ne pas venir en contact avec lesdits premier et second mécanismes de positionnement (10, 20), dans lequel
après exécution de ladite étape (a), lesdits premier et second mécanismes de positionnement sont agencés pour se faire face l'un l'autre le long de ladite direction d'ajustement de position, et pour être situés des deux côtés dudit substrat,
le procédé de positionnement de substrat comprenant en outre les étapes consistant à :
(b) après exécution de ladite étape (a), amener ladite première partie extensible et rétractable (12) à exécuter ladite première opération d'extension et de rétractation, et après avoir amené un premier état d'extension et de rétractation de ladite première partie extensible et rétractable à être ledit état d'extension et de rétractation de référence, arrêter ladite première opération d'extension et de rétractation et régler ledit état d'agencement de référence, de sorte qu'une distance allant d'un centre de ladite table de placement à ladite première partie d'extrémité de pointe (13) est égale à une distance de référence (D1) ;
(c) après exécution de ladite étape (b), amener ladite seconde partie extensible et rétractable (22) à exécuter ladite seconde opération d'extension et de rétractation, de sorte que ladite première partie d'extrémité de pointe vient en contact avec une partie d'extrémité dudit substrat, et ladite seconde partie d'extrémité de pointe (23) vient en contact avec une autre partie d'extrémité dudit substrat ;
(d) après exécution de ladite étape (c), calculer une distance allant du centre de ladite table de placement à ladite seconde partie d'extrémité de pointe en tant que distance de mesure (D2), sur la base d'un second état d'extension et de rétractation de ladite seconde partie extensible et rétractable ;
(e) calculer une longueur de formation dudit substrat dans une direction correspondant à ladite direction d'ajustement de position parmi lesdites première et seconde directions en tant que longueur de formation de substrat de mesure (DW), sur la base de ladite distance de référence et de ladite distance de mesure ; et
(f) sur la base de ladite longueur de formation de substrat de mesure, amener lesdites première et seconde opérations d'extension et de rétractation de sorte que le centre (CL1) dudit substrat correspond au centre (CL2) de ladite table de placement, et
lesdites étapes (b) à (f) sont exécutées en tant que ladite opération de commande de positionnement dudit dispositif de commande (5).
